# EUROPEAN PATENT SPECIFICATION

(11) **EP 2 426 749 B1**
(45) Date of publication and mention of the grant of the patent: **22.04.2015**
(21) Application number: 10174799.6
(22) Date of filing: 01.09.2010
(51) Int. Cl.: H01L 41/053

(54) **Actuator arrangement for use in a fuel injector**
Aktuatoranordnung zur Verwendung mit einem Kraftstoffinjektor
Agencement d'actionneur à utiliser dans un injecteur de carburant

(43) Date of publication of application: 07.03.2012
(73) Proprietor: Delphi International Operations Luxembourg S.à r.l., 4940 Bascharage (LU)
(72) Inventor: Cooke, Michael, Gillingham, Kent ME7 1DR (GB)
(74) Representative: Neill, Andrew Peter

(56) References cited:
- WO-A1-2009/059862
- DE-A1-102007 004 552
- DE-A1-102008 007 202

## Description

### Technical field

The present invention relates to an actuator arrangement for use in a fuel injector of the type intended for use in a fuel system of an internal combustion engine. The invention relates, more particularly, to an encapsulation of an actuator arrangement of a fuel injector of the accumulator or common rail type, the fuel injector being of the type controlled using a piezoelectric actuator.

### Background Art

It is known to use piezoelectric actuators in fuel injectors of internal combustion engines. Such piezoelectrically operable fuel injectors provide a high degree of control over the timing of injection events within the combustion cycle and the volume of fuel that is delivered during each injection event. This permits improved control over the combustion process, which is essential in order to keep pace with increasingly stringent worldwide environmental. Such fuel injectors may be employed in compression ignition (diesel) engines or spark ignition (petrol) engines.

A typical piezoelectric actuator unit designed for use in an automotive fuel injector has a stack structure formed from an alternating sequence of piezoelectric elements or layers and planar internal electrodes. The piezoelectric layers, in turn, form an alternating sequence of oppositely polarised layers, and the internal electrodes form an alternating sequence of positive and negative internal electrodes. The positive internal electrodes are in electrical connection with a first external electrode, hereinafter referred to as the positive side electrode. Likewise, the internal electrodes of the negative group are in electrical connection with a second external electrode, hereinafter referred to as the negative side electrode.

If a voltage is applied between the two external electrodes, the resulting electric fields between each adjacent pair of positive and negative internal electrodes cause each piezoelectric layer, and therefore the piezoelectric stack, to undergo a strain along its length, i.e. along an axis normal to the plane of each internal electrode. Because of the polarisation of the piezoelectric layers, it follows that not only can the magnitude of the strain be controlled by adjusting the applied voltage, but also the direction of the strain can be reversed by switching the polarity of the applied voltage. Rapidly varying the magnitude and/or polarity of the applied voltage causes rapid changes in the strength and/or direction of the electric fields across the piezoelectric layers, and consequentially rapid variations in the length of the piezoelectric actuator. Typically, the piezoelectric layers of the stack are formed from a ferroelectric material such as lead zirconate titanate (PZT).

Such an actuator is suitable for use in a fuel injector, for example of the type known from the present Applicant's European Patent No. EP 0995901. The fuel injector is arranged so that a change in length of the actuator results in a movement of a valve needle. The needle can be thus raised from or lowered onto a valve seat by control of the actuator length so as to permit a quantity of fuel to pass through drillings provided in the valve seat.

In use, the actuator of such a fuel injector is surrounded by fuel at high pressure. The fuel pressure may be up to or above 2000 bar. In order to protect the piezoelectric actuator from damage and potential failure, the piezoelectric actuator must be isolated from this environment by at least a layer of barrier material, herein referred to as 'encapsulation member'. It is known to encapsulate the piezoelectric actuator with an inert fluoropolymer, for example as described in the Applicant's PCT published Patent Application No. WO02/061856A1 (EP 1356529 A), which acts to prevent permeation of liquid fuel, water and contaminant substances dissolved in the water or fuel, into the structure of the actuator.

It has been observed, however, that there may still be ingress of fluid into the interface between the actuator and the polymeric sleeve.

It is known to provide a filler material, as described, for example, in the Applicant's co-pending application WO 02/061856, between the coating and the encapsulated actuator in an attempt to limit the ingress of fluid between the coating and the actuator. However, this requires filling the entire space defined between the coating and the actuator with a curable substance, and may also require a degassing step, which adds to the complexity of the actuator arrangement and the method of assembly.

In a further method, it has been proposed to use a metal tube around the piezoelectric actuator. In EP 1 956 229 A1, the applicant discloses such metal tube for the encapsulation of piezoelectric actuators wherein the metallic tube comprises two types of strain compensation formations, the formations can be extended parallel to the longitudinal axis and the second formations deflected inwardly transversally to the longitudinal axis of the piezoelectric actuator.

EP1854996 describes a piezoelectric actuator arrangement for a fuel injector that includes a corrugated metal enclosure surrounding the piezoelectric stack and containing a passivation fluid medium in contact with the stack. Said piezoactuator for injecting fuel with a predetermined fuel pressure has an at least laterally narrowing casing around the internal space of the actuator which has a first temperature and/or pressure-dependent volume change, a piezo stack located in the internal space which has a second temperature and/or pressure-dependent volume change, a transmission element which is located between the piezo stack and the casing for transmitting the fuel pressure on the outside of the casing onto the piezo stack, wherein the transmission element has a passivating liquid which has a third temperature- and/or pressure-dependent volume change as well as several preformed bodies which have a fourth temperature- and/or pressure-dependent volume change; wherein the relation between the passivating liquid and the preformed bodies is set that the first volume change of the casing basically corresponds to an overall internal space volume change which has at least the second, third, and fourth volume change.

EP2079113 describes a piezo-electric actuator for use in a diesel engine. The actuator comprises a piezo-electric element which is encapsulated such that a layer of gas at a pressure above atmospheric pressure surrounds the piezo-electric element. The presence of the gas within the encapsulation around the element avoids the need to passivate electrodes exposed on the surface of the element. The encapsulation is made from stainless steel and is provided with corrugations which enable it to expand or contract in length in a direction along its longitudinal axis.

Against this background, the main object of the present invention is to provide an alternative method of encapsulation that, when applied to a piezoelectric actuator, greatly reduces fuel (diesel/gasoline) and water permeation and thus improves the lifetime of piezoelectrically driven injectors.

### Summary of the Invention

This object is achieved by an actuator arrangement for use in a fuel injector, comprising: a piezoelectric actuator having a body section, said body section having a first end piece and a second end piece; an encapsulation member which encloses the body section between the end pieces, wherein potting material is fitted between the encapsulation member and the body section, wherein the encapsulation member has a corrugated bellows form comprising a plurality of corrugations over its entire length and is of a rectangular cross section with rounded corners and adjoining flattened sections.

The flattened section preferably havei a 1/r from -0.5 to +0.14 mm⁻¹, wherein r is the radius of curvature of the flattened sections.

The present actuator arrangement has thus a bellows design, which achieves low stresses for axial displacement, temperature changes and external pressure loading. It represents the optimum for surviving temperature loading and external pressure on the one hand and the optimum for surviving axial displacement of the actuator on the other hand.

Piezo-electric actuators are sensitive to moisture as the high voltages in them can cause electrochemical migration of metallic elements between their electrodes in the presence of moisture. To protect such actuators from moisture, it is known to encapsulate them within a metallic encapsulation member (can) (e.g. US7531944). In some piezo-electric injectors (e.g. EP0995901), the actuator is located in the high pressure fuel which is to be injected. Analysis made by the applicant on encapsulation members has shown that there is a compromise to be made between the optimum geometry for surviving temperature loading and external pressure and the optimum for surviving axial displacement of the actuator. This analysis found that the optimum design actually ended up with an actuator arrangement with an encapsulation member comprising bellows over the entire length all bellows and no flat i.e. non corrugated sections between them unlike in US7531944. From EP2079113, it is also known to make the encapsulation member in the form of a round bellows Such a bellows has also been analyzed and have been found to be suitable for surviving axial displacement of the actuator, but poor at surviving pressure and temperature loading.

Because of the substantially rectangular cross-section with rounded corners and adjoining flattened sections, the volume of filler material can be reduced and the encapsulation member is made more able to change in volume without generating high stresses.

A major advantage of the above actuator arrangement is to provide a piezoelectric actuator stack, which is easy to manufacture and has an excellent resistance to mechanical stress as far as originated from temperature loading, external pressure and axial displacement are concerned.

The rigid encapsulation member comprises preferably a metallic tube, preferably made of steel, stainless steel, nickel, gold, chromium, titanium, copper, cobalt, zinc or one of their alloys. More preferably, the encapsulation member is made of stainless steel.

The term "rigid" as used herein means that it cannot be deformed easily and is meant to designate the category of encapsulation members where there are "soft" encapsulation members usually made of a sheet of polymeric materials and "rigid" encapsulation members usually made of metal.

The walls of said metallic tube is according to a preferred embodiment a thickness of between about 0.02 and 0.2 mm preferably of about 0.1 mm. Such a rigid encapsulation member does not yield or is not deformed in a substantial way under the pressures use in fuel injectors.

The corrugations of the encapsulation member preferably have a depth measured from peak to bottom ranging from 0.2 to 0.6 mm

The corrugations of the encapsulation member advantageously have a length measured from peak to peak to ranging from 0.8 to 1.5 mm.

A potting material or filler material suitable for use with the invention is a rubber, preferably a silicone or a fluorosilicone rubber, silicone, a polymer preferably a silicone resin or an epoxy resin, a powder preferably silica or metal oxides or a liquid preferably fluorocarbons or hydrocarbons or a combination of these products , although alternative minimally-compressive materials with similar properties may be used instead. Desirable properties of a dielectric filler materials include: heat resistance; heat transfer ability, to absorb heat from the piezoelectric stack for transfer to the enclosure and from there to the fuel flowing around the enclosure; low water solubility; low viscosity; and low surface tension, to facilitate filling the intricate enclosure. Fluorinert FC-43, a liquid, is a particularly useful selection as it has all of these properties and further, it is projected to compress by only 16% at 2000 bar.

In order to further reduce the compressibility of the potting materials, filler materials such as silica or metal oxides can be added.

To minimize the stresses at the ends, it is advantageous for the first corrugation of the encapsulation member to overlap the edge of the end piece 18 i.e the part of the end piece which is contact with the piezo-electric stack.

### Brief Description of the Drawings

Embodiments of the present invention will now be described, by way of example only, with reference to the accompanying drawing, in which:

Figure 1 is a perspective view of an encapsulated piezoelectric actuator arrangement in accordance with a preferred embodiment of the present invention,

Figure 2 shows the actuator arrangement of Figure 1 with part of the encapsulation member removed,

Figure 3 shows an axial section zoomed in on the end of the actuator close to end piece,

Figure 4 shows a cross-section of the actuator of Figure 1,

Figure 5 shows a cross-section of a further preferred embodiment of the actuator of Figure 1,

Figure 6 shows a graph of the stresses caused by thermal expansion and form actuator displacement versus 1/r.

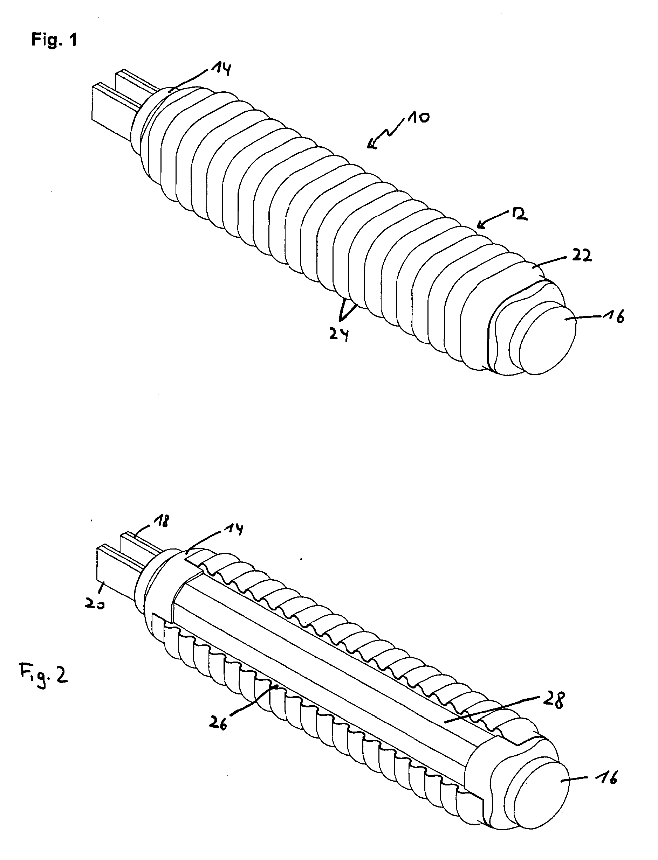

The actuator arrangement 10 as shown in the perspective view of Figure 1 includes a generally cylindrical body section , comprising: a central major portion containing a piezoelectric stack; and first and second end pieces 14 and 16 respectively. End piece 14, at the first end of body section, includes an electrical connector with first and second terminals 18, 20, which in use receives a voltage from a voltage supply (not shown). End piece 16, at the second end of body section, includes a load transmitting member which in use co-operates with a control piston or valve needle (not shown) of the fuel injector.

Details of the piezoelectric stack and internal components of actuator 10 and a description of how the actuator operates are disclosed fully in the Applicant's granted patent EP 0995901, so will not be discussed here.

Evident from FIG. 1 is the presence of a rigid encapsulation member 22, - a rigid tube - which envelops the body section and extends along the length of body section 12 from end piece 14 to end piece 16.

The rigid encapsulation member 22 comprises corrugations in a "bellows" form 24 over its entire length, except where joined to end pieces 14, 16. The encapsulation member 22 would typically be made of a metal such as stainless steel, or of nickel, gold, chromium, titanium, copper, cobalt, zinc or one of their alloys. A ceramic, glass or composite could also be used. The cross-section of the encapsulation member 22 bellows is of a substantially rectangular or substantially square, i.e. "non-round" shape and has chamfered or "rounded" corners. As can be seen on the figures the corrugations form a regular pattern and show no sharp edges.

Figure 2 shows the actuator arrangement 10 of Figure 1 with part of the encapsulation member 22 removed to expose a filler material or potting material 26 and the piezo-electric stack 28. For an actuator 10 to be used inside the high pressure part of a diesel fuel injector, it would be impossible to make an impermeable encapsulation member 22 which was strong enough to resist the pressure trying to crush it and which was also at the same time thin enough to permit enough axial displacement of the actuator. For this reason, the filler material 26 must substantially completely fill the space between the stack 28 and the encapsulation member 22 so that it can provide a counter-pressure to resist crushing of the encapsulation member. A problem however is that suitable fillers tend to have a thermal expansion coefficient of one or two orders of magnitude higher than that of the piezo-stack 28 or the encapsulation member 22. When the actuator 10 is heated, the filler material 26 therefore expands, generating high pressures inside the encapsulation member 22. In order to minimize this problem, the filler material 26 must have a minimum volume and the encapsulation member 22 must be strong, but capable of increasing in internal volume relatively easily. When pressurized from the outside, the encapsulation member must also be able to transmit pressure to the filler, so it must be able to decrease in internal volume without excessive stresses. The filler material or potting material would typically be a rubber such as a silicone or a fluorosilicone rubber, polymer such as a Silicone resin or an epoxy resin, powder such as silica or metal oxides or liquid such as fluorocarbons or hydrocarbons. For example a silicone rubber or fluorosilicone rubber could be used and may be filled with a powder such as silica or various metal oxides to minimize its thermal expansion coefficient and compressibility.

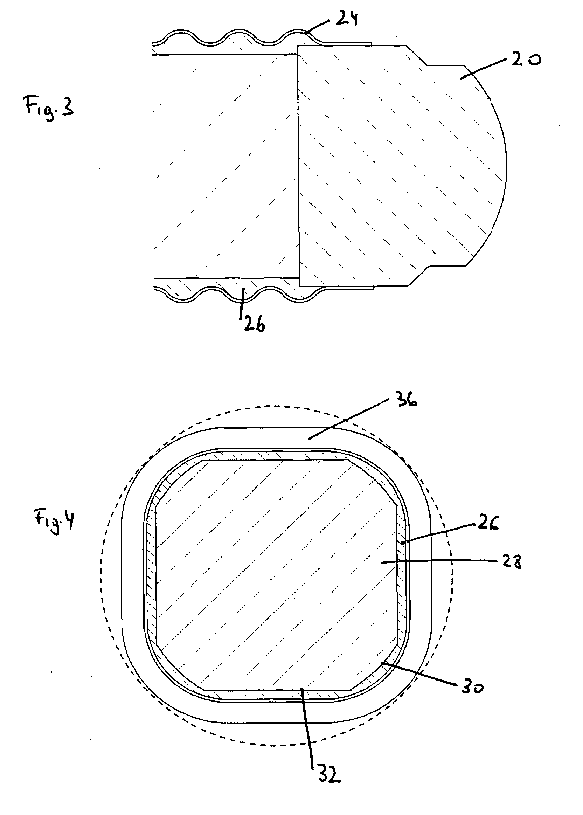

Figure 3 shows an axial section zoomed in on the end of the actuator close to end piece 16. To minimize the stresses at the ends, it is advantageous for the first corrugation of the encapsulation member 22 to overlap the edge of the end piece 16 as shown in Fig. 3 with regard to the second end piece 16.

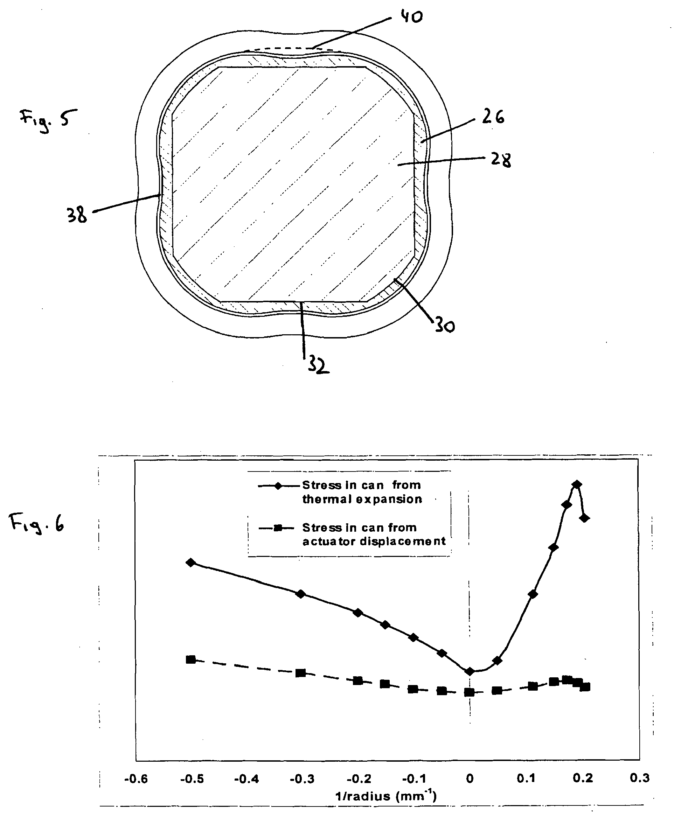

Figure 4 and Figure 5 show a cross-section of the actuator. The piezo-electric stack 28 is typically of a generally square shape with chamfered or rounded off corners 30 because for high volume manufacture it is usually sliced out of a block. The sections 32 of the piezo electric stack 24 adjacent to the chamfered or rounded off corners are flattened.

The encapsulation member has a cross-section that substantially follows the contours of the piezo-electric stag 28 except that it has no sharp edges, the corners of the encapsulation member 22 are rounded and the adjacent sections 40 of the encapsulation member 22 are either flat (as shown on Figure 4) respectively slightly concave or slightly convex as shown on Figure 5.

Between the encapsulation member 22 and the piezo-electric stack 28, the potting material 26 is shown. The closely spaced double line represents the outside and inside surface of the metal sectioned through the bottom of a corrugation. There could be cross-hatching between them, but it is conventionally omitted on such thin sections. The wider spaced outermost line is the top of the adjacent corrugation.

Because of the substantially rectangular or square cross-section of the encapsulation member with rounded corners and flattened sections between two corners, the volume of potting material can be reduced and the encapsulation member 22 made more able to change in volume without generating high stresses.

As shown in figure 5, depending on the exact materials and operating conditions it can be advantageous to have a slightly concave 38 or convex 40 in the "flattened" areas.

Figure 6 shows a graph of the stresses (by Finite Element Analysis) in a filled actuator with a full length bellows encapsulation member as the geometry of the flattened sections is varied from a highly concave form on the left to a completely round can on the right. The lowest stresses can be observed to be close to a flattened form. At the left side of the graph (concave surface) there is a high stress in the concave surface itself. When the surface is nearer to flat (1/r is closer to zero), there is a relatively even stress distribution around the encapsulation member. When the surface is convex, the encapsulation member tends to bend around the thinnest section of the filler, to give a higher stress in that region.

The manufacture of the bellows would typically be done by plastic deformation of a tube by processes such as hydroforming, but it could also be formed by an electro-deposition process.

### Legend:

- 10: actuator arrangement
- 12: body section
- 14: first end piece
- 16: second end piece
- 18: first terminal
- 20: second terminal
- 22: encapsulation member
- 24: corrugations in a bellows form
- 26: potting material, filler material
- 28: piezo-electric stack chamfered corner of the piezo-
- 30: electric stack flattened section of the piezo-
- 32: electric stack corner of the encapsulation
- 34: member flattened section of the
- 36: encapsulation member concave flattened section of the
- 38: encapsulation member convex flattened section of the
- 40: encapsulation member

## Claims

1. An actuator arrangement (10) for use in a fuel injector, comprising:
a piezoelectric actuator having a body section (12), said body section having a first end piece (14) and a second end piece (16);
an encapsulation member (22) which encloses the body section between the end pieces, wherein potting material (26) is fitted between the encapsulation member and the body section, wherein the encapsulation member has a corrugated bellows form comprising a plurality of corrugations (24) over its entire length and is of a substantially rectangular cross section with rounded corners and adjoining flattened sections.

2. The actuator arrangement according to claim 1, wherein the flattened section having a 1/r from -0.5 to +0.14 mm-1, wherein r is the radius of curvature of the flattened sections.

3. The actuator arrangement according to any of the preceding claims, wherein the encapsulation member comprises a metallic tube made of steel, stainless steel, nickel, gold, chromium, titanium, copper, cobalt, zinc or one of their alloys.

4. The actuator arrangement according to any of the preceding claims, wherein the encapsulation member has a thickness of between about 0.02 and 0.2 mm preferably of about 0.1 mm.

5. The actuator arrangement according to any of the preceding claims, wherein the corrugations of the encapsulation member have a depth measured from peak to bottom ranging from 0.2 to 0.6 mm.

6. The actuator arrangement according to any of the preceding claims, wherein the corrugations of the encapsulation member have a length measured from peak to peak to ranging from 0.8 to 1.5 mm.

7. The actuator arrangement according to any of the preceding claims, wherein the potting material is selected from the group consisting of rubber, preferably a silicone or a fluorosilicone rubber, silicone, a polymer preferably a silicone resin or an epoxy resin, a powder preferably silica or metal oxides or a liquid preferably fluorocarbons or hydrocarbons or a combination of these products.

8. The actuator arrangement according to any of the preceding claims, wherein the at least one corrugation of the encapsulation member overlaps an edge of said end piece.

## Patentansprüche

1. Aktoranordnung (10) zur Verwendung in einer Kraftstoffeinspritzvorrichtung, umfassend:
einen piezoelektrischen Aktor, der einen Körperabschnitt (12) hat, wobei der genannte Körperabschnitt ein erstes Endstück (14) und ein zweites Endstück (16) hat,
ein Kapselungselement (22), das den Körperabschnitt zwischen den Endstücken umschließt, wobei zwischen dem Kapselungselement und dem Körperabschnitt Vergussmaterial (26) eingefügt ist, wobei das Kapselungselement eine wellige Faltenbalgform hat, die auf ihrer ganzen Länge eine Vielzahl von Wellungen (24) aufweist und einen im Wesentlichen rechteckigen Querschnitt mit abgerundeten Ecken und angrenzenden abgeflachten Abschnitten hat.

2. Aktoranordnung nach Anspruch 1, wobei der abgeflachte Abschnitt ein 1/r von -0,5 bis +0,14 mm-1 hat, wobei r der Krümmungsradius der abgeflachten Abschnitte ist.

3. Aktoranordnung nach einem der vorhergehenden Ansprüche, wobei das Kapselungselement eine metallische Röhre aus Stahl, rostfreiem Stahl, Nickel, Gold, Chrom, Titan, Kupfer, Kobalt, Zink oder einer ihrer Legierungen umfasst.

4. Aktoranordnung nach einem der vorhergehenden Ansprüche, wobei das Kapselungselement eine Dicke zwischen etwa 0,02 und 0,2 mm, vorzugsweise von etwa 0,1 mm hat.

5. Aktoranordnung nach einem der vorhergehenden Ansprüche, wobei die Wellungen des Kapselungselements eine von der Spitze zum Boden gemessene Tiefe haben, die von 0,2 bis 0,6 mm reicht.

6. Aktoranordnung nach einem der vorhergehenden Ansprüche, wobei die Wellungen des Kapselungselements eine von Spitze zu Spitze gemessene Länge haben, die von 0,8 bis 1,5 mm reicht.

7. Aktoranordnung nach einem der vorhergehenden Ansprüche, wobei das Vergussmaterial aus der Gruppe bestehend aus Gummi, vorzugsweise einem Silikon oder einem Fluor-Silikon-Kautschuk, Silikon, einem Polymer, vorzugsweise einem Silikonharz oder einem Epoxidharz, einem Pulver, vorzugsweise Siliziumdioxid oder Metalloxiden, oder einer Flüssigkeit, vorzugsweise Fluorkohlenstoffen oder Kohlenwasserstoffen, oder einer Kombination dieser Produkte ausgewählt ist.

8. Aktoranordnung nach einem der vorhergehenden Ansprüche, wobei die wenigstens eine Wellung des Kapselungselements einen Rand des genannten Endstücks überlappt.

## Revendications

1. Agencement actionneur (10) destiné à être utilisé dans un injecteur de carburant, comprenant :
un actionneur piézoélectrique ayant une section de corps (12), ladite section de corps ayant une première pièce terminale (14) et une seconde pièce terminale (16) ;
un élément d'encapsulage (22) qui enferme la section de corps entre les pièces terminales, dans lequel un matériau de remplissage (26) est logé entre l'élément d'encapsulage et la section de corps, dans lequel l'élément d'encapsulage a la forme d'un soufflet ondulé comprenant une pluralité d'ondulations (24) sur sa longueur entière et a une section transversale sensiblement rectangulaire avec des coins arrondis et des sections aplaties jointives.

2. Agencement actionneur selon la revendication 1, dans lequel la section aplatie est telle que 1/r est de -0,5 à +0,14 mm⁻¹, dans laquelle r et le rayon de courbure des sections aplaties.

3. Agencement actionneur selon l'une quelconque des revendications précédentes, dans lequel l'élément d'encapsulage comprend un tube métallique réalisé en acier, acier inoxydable, nickel, or, chrome, titane, cuivre, cobalt, zinc ou l'un de leurs alliages.

4. Agencement actionneur selon l'une quelconque des revendications précédentes, dans lequel l'élément d'encapsulage a une épaisseur entre environ 0,02 et 0,2 mm, de préférence d'environ 0,1 mm.

5. Agencement actionneur selon l'une quelconque des revendications précédentes, dans lequel les ondulations de l'élément d'encapsulage ont une profondeur, mesurée de la pointe au fond, allant de 0,2 à 0,6 mm.

6. Agencement actionneur selon l'une quelconque des revendications précédentes, dans lequel les ondulations de l'élément d'encapsulage ont une longueur, mesurée de pointe à pointe, allant de 0,8 à 1,5 mm.

7. Agencement actionneur selon l'une quelconque des revendications précédentes, dans lequel le matériau de remplissage est choisi panni le groupe comprenant caoutchouc, de préférence caoutchouc au silicone ou caoutchouc au fluorosilicone, silicone, polymère, de préférence résine au silicone ou résine époxy, une poudre, de préférence de silice, ou oxydes métalliques, ou un liquide, de préférence fluorocarbures ou hydrocarbures, ou une combinaison de ces produits.

8. Agencement actionneur selon l'une quelconque des revendications précédentes, dans lequel ladite au moins une ondulation de l'élément d'encapsulage chevauche un bord de ladite pièce terminale.
